# EUROPEAN PATENT APPLICATION

(11) **EP 2 302 985 A1**
(43) Date of publication of application: **30.03.2011**
(21) Application number: 09171433.7
(22) Date of filing: 28.09.2009
(51) Int. Cl.: H05K 1/02, F21V 19/00

(54) **LED assembly**

(71) Applicant: Huang, Huan-Chang, Guishan Township T'ao yuan (TW)
(72) Inventor: Huang, Huan-Chang, Guishan Township T'ao yuan (TW)
(74) Representative: Chaillot, Geneviève

(57) **Abstract**

An LED assembly includes a circuit board, one or more LED modules, one or more positioning plates and a heat dissipating plate. One or more openings are disposed in the circuit board. An electric terminal is provided on either side of each hole. A circuit pattern is provided on the circuit board to allow a parallel connection of each electric terminal. The heat dissipating plate is installed under the circuit board. Several connective holes are provided in the heat dissipating plate. In assembly, each hole is aligned with the corresponding LED module and the positioning plate is installed on top of the corresponding LED module. Several fasteners are used to fixedly connect the positioning plates, LED modules, circuit board and heat dissipating plate together. Therefore, the LED modules may be securely fixed.

## Description

### BACKGROUND OF THE INVENTION

### 1. Field of the invention

The invention generally relates to an LED assembly. More particularly, the invention relates to an LED assembly that allows swift assembly and partial disassembly.

### 2. Description of the prior art

Lights have been widely used in our life. They allow us to read in nights and provide indoor lighting.

As of now, LEDs have been used for lighting and LED lights may be quite bright. However, because LEDs are usually disposed on the same circuit board, the whole set of LEDs has to be replaced when a single LED of them malfunctions. Therefore, this is not economical for consumer public.

From the above, we can see that the LED lights of the prior art have disadvantages and need to be improved.

To eliminate the disadvantages of the LED lights of the prior art, the inventor has put a lot of effort into the subject and has successfully come up with the LED assembly of the present invention.

### SUMMARY OF THE INVENTION

An object of the present invention is to provide an LED assembly that allows swift assembly and partial disassembly.

Another object of the present invention is to provide an LED assembly that is structurally simple and easy to use and allows swift disassembly.

To reach these objects, the LED assembly of the present invention comprises a circuit board, one or more LED modules, one or more positioning plates and a heat dissipating plate. One or more openings are disposed in the circuit board. An electric terminal is provided on either side of each hole. A circuit pattern is provided on the circuit board 1 to allow the positive lead of each electric terminal may be connected in parallel and the negative lead of each electric terminal may also be connected in parallel. The heat dissipating plate is installed under the circuit board. Several connective holes are provided in the heat dissipating plate. Also, a male electric terminal extends outwards from either side of each LED module. The two male electric terminals assist each LED module to be seated in the opening (so that each male electric terminal may engage with the corresponding electric terminal). Several holes are provided in each LED module. In assembly, each hole is aligned with the corresponding LED module and the positioning plate is installed on top of the corresponding LED module. Several fasteners are used (by passing through the holes of the positioning plates, LED module and the circuit board) to fixedly connect the positioning plates, LED modules, circuit board and heat dissipating plate together. Therefore, the LED modules may be securely fixed.

An object of the invention is a LED assembly, comprising:
a circuit board, wherein an opening is disposed in the circuit board and an electric terminal is provided on either side of the opening, and a first connective hole is provided by electric terminal;
a LED module, wherein a first hole is disposed in the LED module and a male electric terminal extends outwards from either side of the LED module, and the male electric terminal corresponds to the electric terminal and the male electric terminal assists the LED module to be seated in the opening;
a positioning plate, wherein a through opening is disposed in the positioning plate and a second hole is provided on either side of the through opening, and the second hole corresponds to the first connective hole, in assembly, the through opening is aligned with the LED module and the positioning plate is installed on top of the LED module; and
a heat dissipating plate, wherein a second connective hole that corresponds to the first hole is provided in the heat dissipating plate and the heat dissipating plate is installed under the circuit board, and a fastener is used by passing through the holes to fixedly connect the positioning plate, the LED module, the circuit board and the heat dissipating plate together.

Preferably, a reflective layer is provided on the outer surface of the circuit board.

Preferably, a circuit pattern is provided on the circuit board to allow a positive lead of the electric terminal connected in parallel and a negative lead of the electric terminal connected in parallel.

Preferably, a reflective layer is provided on the outer surface of the positioning plate.

These features and advantages of the present invention will be fully understood and appreciated from the following detailed description of the accompanying Drawings.

### BRIEF DESCRIPTION OF THE DRAWINGS

Fig. 1 is a perspective, exploded view illustrating the LED assembly of the present invention.
Fig. 2 is a perspective view illustrating the LED assembly of the present invention in an assembled condition.
Fig. 3 is a perspective view illustrating the LED assembly of the present invention in actual use.
Fig. 4 is a perspective view illustrating another embodiment of the present invention.

### DESCRIPTION OF THE PREFERRED EMBODIMENT

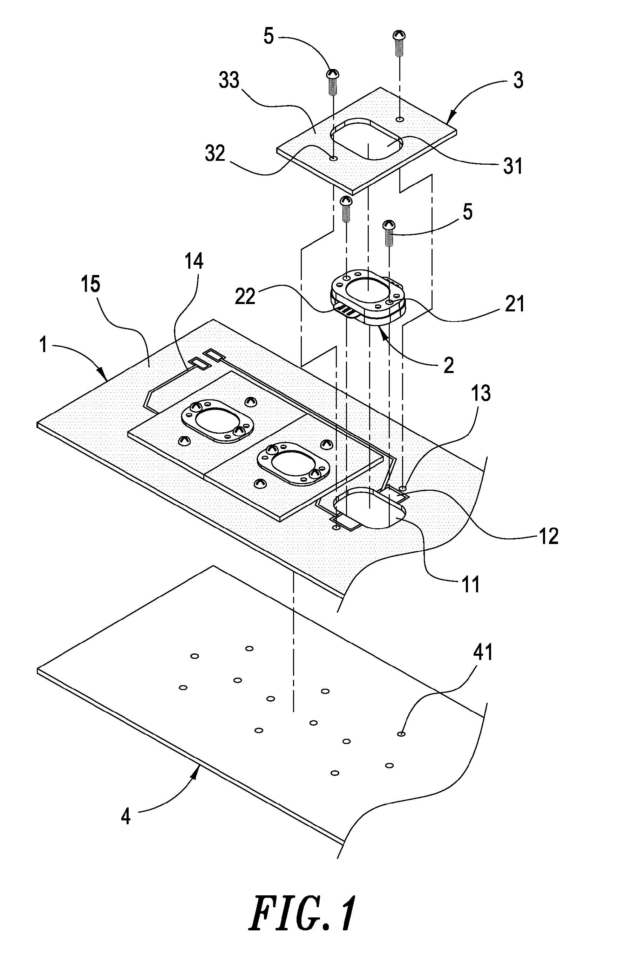

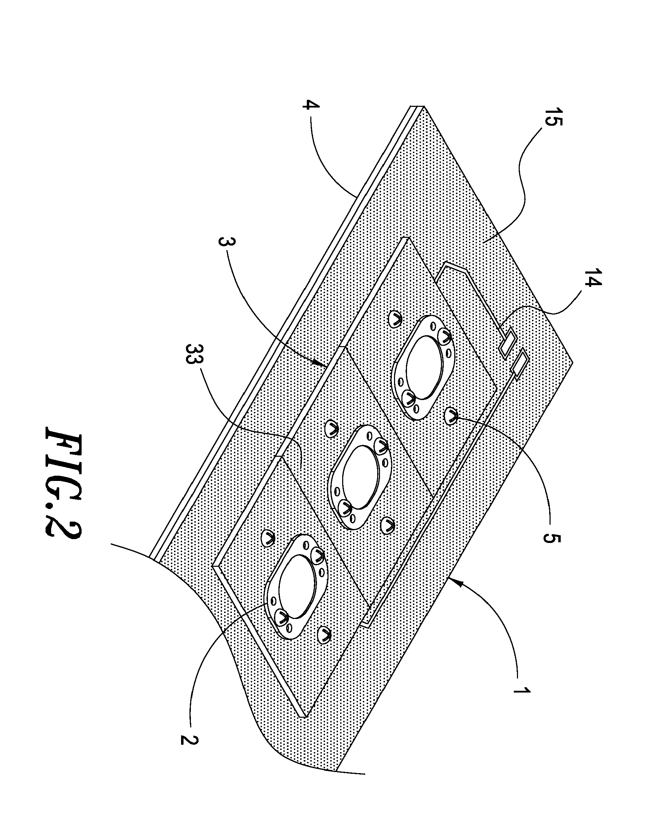

Please refer to Figs. 1 and 2. Fig. 1 is a perspective, exploded view illustrating the LED assembly of the present invention. Fig. 2 is a perspective view illustrating the LED assembly of the present invention in an assembled condition. The LED assembly of the present invention comprises a circuit board 1, one or more LED modules 2, one or more positioning plates 3 and a heat dissipating plate 4. One or more openings 11 are disposed in the circuit board 1. An electric terminal 12 is provided on either side of each opening 11. A connective hole 13 is provided by each electric terminal 12. A circuit pattern 14 is provided on the circuit board 1 to allow the positive lead of each electric terminal 12 may be connected in parallel and the negative lead of each electric terminal 12 may also be connected in parallel. A reflective layer 15 is provided on the outer surface of the circuit board 1. One or more holes 21 are disposed on each LED module 2. Also, a male electric terminal 22 extends outwards from either side of each LED module 2. Each male electric terminal 22 corresponds to an electric terminal 12. The two male electric terminals 22 assist each LED module 2 to be seated in the opening 11 (so that each male electric terminal 22 may engage with the corresponding electric terminal 12). A through opening 31 is disposed in each positioning plate 3. A hole 32 is provided on either side of each opening 31. Each hole 32 corresponds to or is aligned with a connective hole 13. A reflective layer 33 is provided on the outer surface of each positioning plate 3. In assembly, each opening 31 is aligned with the corresponding LED module 2 and the positioning plate 3 is installed on top of the corresponding LED module 2. Several connective holes 41 that correspond to the holes of the circuit board 1 and LED modules 2 are provided in the heat dissipating plate 4. The heat dissipating plate 4 is installed under the circuit board 1. Several fasteners 5 are used (by passing through the holes 21, 32 and 41) to fixedly connect the positioning plates 3, LED modules 2, circuit board 1 and heat dissipating plate 4 together. Therefore, the LED modules 2 may be securely fixed.

The openings 11 and positioning plates 3 can substantially reduce the time for assembly and disassembly. In addition, because each LED module 2 is fitted in the corresponding opening 11, only the malfunctioned LED module(s) 2 needs to be taken off and replaced; in contrast, in the prior art, the whole LED set needs to be replaced. This makes the LED assembly of the present invention more economical in use.

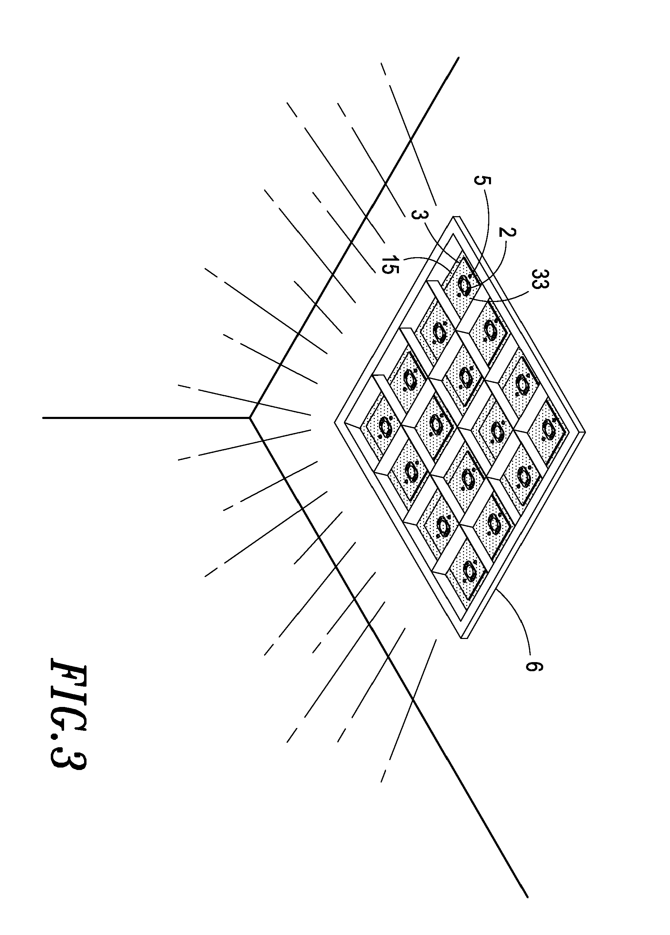

Please refer to Fig. 3, which is a perspective view illustrating the LED assembly of the present invention in actual use. In Fig. 3, several LED assemblies 2 of the present invention are fitted onto an office light fixture 6. When the LEDs are lit, the two reflective layers 15 and 33 can effectively disperse the light so that the light would be spread out evenly.

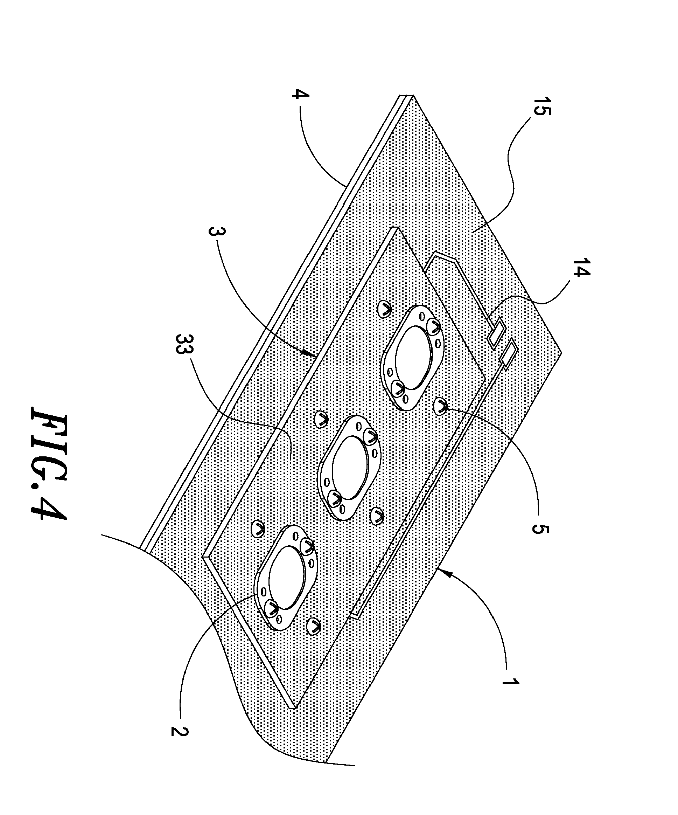

Now, please see Fig. 4, which is another embodiment of the present invention. Two openings 31 or three openings 31 or four openings 31 may be disposed in the positioning plate 3 (without affecting the swift assembly and disassembly of the LED assembly of the present invention).

Also, the heat dissipating plate 4 may have a fin type design or other type of heat dissipating design.

In comparison to the prior art, the LED assembly of the present invention has the following advantages:
1. In the LED assembly of the present invention, swift assembly and partial disassembly may be achieved.
2. The openings of the circuit board and the positioning plates can substantially reduce the time for assembly and disassembly.
3. Because each LED module is fitted in the corresponding opening, only the malfunctioned LED module(s) needs to be taken off and replaced; in contrast, in the prior art, the whole LED set needs to be replaced. This makes the LED assembly of the present invention more economical in use.
4. The LED assembly of the present invention is structurally simple and easy to use and allows swift disassembly.

Many changes and modifications in the above described embodiments of the invention can, of course, be carried out without departing from the scope thereof. Accordingly, to promote the progress in science and the useful arts, the invention is disclosed and is intended to be limited only by the scope of the appended claims.

## Claims

1. An LED assembly, comprising:
a circuit board (1), wherein an opening (11) is disposed in the circuit board and an electric terminal (12) is provided on either side of the opening (11), and a first connective hole (13) is provided by electric terminal (12);
a LED module (2), wherein a first hole (21) is disposed in the LED module (2) and a male electric terminal (22) extends outwards from either side of the LED module (2), and the male electric terminal (22) corresponds to the electric terminal (12) and the male electric terminal (22) assists the LED module (2) to be seated in the opening (11);
a positioning plate (3), wherein a through opening (31) is disposed in the positioning plate (3) and a second hole (32) is provided on either side of the through opening (31), and the second hole (32) corresponds to the first connective hole (13), in assembly, the through opening (31) is aligned with the LED module (2) and the positioning plate (3) is installed on top of the LED module (2); and
a heat dissipating plate (4), wherein a second connective hole (41) that corresponds to the first hole is provided in the heat dissipating plate (4) and the heat dissipating plate (4) is installed under the circuit board (1), and a fastener (5) is used by passing through the holes (21, 32 and 41) to fixedly connect the positioning plate (3), the LED module (2), the circuit board (1) and the heat dissipating plate (4) together.

2. The LED assembly as in claim 1, wherein a reflective layer (15) is provided on the outer surface of the circuit board (1).

3. The LED assembly as in claim 1, wherein a circuit pattern (14) is provided on the circuit board (1) to allow a positive lead of the electric terminal (12) connected in parallel and a negative lead of the electric terminal (12) connected in parallel.

4. The LED assembly as in claim 1, wherein a reflective layer (33) is provided on the outer surface of the positioning plate (3).
